# EUROPÄISCHE PATENTANMELDUNG

(11) **EP 4 216 690 A1**
(43) Veröffentlichungstag der Anmeldung: **26.07.2023**
(21) Anmeldenummer: 23152638.5
(22) Anmeldetag: 20.01.2023
(51) Int. Cl.: H05K 7/20

(54) **KÜHLKÖRPER ZUR KÜHLUNG VON ELEKTRONISCHEN BAUELEMENTEN UND ANORDNUNG MIT EINEM KÜHLKÖRPER**

(30) Priorität: 24.01.2022 DE 102022200734
(71) Anmelder: Robert Bosch GmbH, 70442 Stuttgart (DE)
(72) Erfinder: Mielke, Christian, 15344 Strausberg (DE); Holp, Reiner, 72474 Winterlingen (DE); Scholz, Benedikt, 70825 Korntal (DE); Steiner, Martin, 72116 Moessingen (DE); Grosse, Ralf Manfred, 72501 Gammertingen (DE)

(57) **Zusammenfassung**

Die Erfindung betrifft einen Kühlkörper (10) zur Kühlung von elektronischen Bauelementen, mit einem Grundkörper (12), der eine Umfangswand (20) zur Begrenzung eines Kühlraums (16) aufweist, mit einem innerhalb des Kühlraums (16) angeordneten, vorzugsweise plattenförmigen Trägerelement (18), das auf gegenüberliegenden Seiten eine erste Kühlfläche (42) und eine zweite Kühlfläche (44) aufweist, die dazu ausgebildet sind, die Bauelemente mittels eines Kühlmediums zumindest mittelbar zu kühlen, wobei die erste Kühlfläche (42) im Bereich einer U-förmigen Vertiefung (46) angeordnet ist, die mittels einer Verschlussplatte (14) mediendicht verschließbar ist.

## Beschreibung

### Technisches Gebiet

Die Erfindung betrifft einen Kühlkörper zur Kühlung von elektronischen Bauelementen, der sich durch eine konstruktiv vorteilhafte Ausbildung zur Aufnahme der Bauelemente und des Anschlusses des Kühlkörpers an ein weiteres, zu kühlendes Aggregat auszeichnet. Ferner betrifft die Erfindung eine Anordnung mit einem erfindungsgemäßen Kühlkörper und einem mit dem Kühlkörper in Form einer elektrischen Maschine ausgebildeten Aggregat.

### Stand der Technik

Kühlkörper zur Kühlung von elektronischen Bauelementen sind in vielfältiger Art und Weise und konstruktiven Ausführungen bekannt. So ist es z.B. aus der US 7,633,758 B2 bekannt, dass mittels eines Trägerelements eine Kühlung von beidseitig des Trägerelements angeordneten Bauelemente durch Wärmeleitung erfolgen kann.

Weiterhin ist es aus der DE 10 2017 201 410 B3 bekannt, eine Führung eines der Kühlung dienenden Luftstroms entlang eines U-förmig ausgebildeten Kühlkanals im Kühlkörper vorzusehen.

### Offenbarung der Erfindung

Der erfindungsgemäße Kühlkörper zur Kühlung von elektronischen Bauelementen mit den Merkmalen des Anspruchs 1 hat den Vorteil, dass er bei besonders kompakter Bauweise die Kühlung einer Vielzahl von Bauelementen ermöglicht und insbesondere auch dazu ausgebildet ist, mittels eines der Kühlung der elektronischen Bauelemente dienenden Mediums gleichzeitig ein mit dem Kühlkörper verbindbares, anderes Aggregat zu kühlen.

Die oben genannten Vorteile werden bei einem Kühlkörper zur Kühlung von elektronischen Bauelementen dadurch erzielt, dass dieser einen Grundkörper mit einer umlaufenden Umfangswand zur Begrenzung eines Kühlraums aufweist, wobei innerhalb des Kühlraums ein vorzugsweise plattenförmiges Trägerelement angeordnet ist, das auf gegenüberliegenden Seiten eine erste Kühlfläche und eine zweite Kühlfläche aufweist, die dazu ausgebildet sind, die Bauelemente mittels eines Kühlmediums zumindest mittelbar zu kühlen, wobei die erste Kühlfläche im Bereich einer U-förmigen Vertiefung, die als Kühlkanal dient, angeordnet ist, der mittels einer Verschlussplatte mediendicht verschließbar ist, wobei der Grundkörper auf der Seite der zweiten Kühlfläche offen ausgebildet ist, derart, dass der Grundkörper mittels der Umfangswand gegen ein mit dem Kühlkörper verbindbares Aggregat mediendicht verbindbar ist, sowie mit einem Kühlmitteleinlass, der dazu ausgebildet ist, Kühlmedium zumindest mittelbar dem Bereich der ersten Kühlfläche des Trägerelements zuzuführen und einem Kühlmittelauslass zum Ausleiten des Kühlmediums aus dem Kühlraum auf der Seite der zweiten Kühlfläche des Trägerelements.

Vorteilhafte Weiterbildungen des erfindungsgemäßen Kühlkörpers zur Kühlung von elektronischen Bauelementen sind in den Unteransprüchen aufgeführt.

Ganz besonders bevorzugt ist es, wenn die Verschlussplatte und der Grundkörper im Bereich des Trägerelements mittels einer Rührreibschweißverbindung miteinander stoffschlüssig verbunden sind. Eine derartige Rührreibschweißverbindung ermöglicht eine besonders steife Ausbildung des Kühlkörpers und sorgt gleichzeitig für die mediendichte Ausbildung des Kühlraums.

Weiterhin ist es besonders bevorzugt, wenn der Grundkörper zusammen mit dem Trägerelement als einstückiges, monolithisches Bauteil ausgebildet ist. Hierbei kann es insbesondere vorgesehen sein, dass das Bauteil als Druckgussteil oder als Schmiedeteil ausgebildet ist.

Eine weitere bevorzugte Ausgestaltung des Kühlkörpers sieht vor, dass zwischen der Umfangswand am Grundkörper und dem Trägerelement Durchbrüche in Art von Überströmkanälen für das (Kühl-) Medium ausgebildet sind, die die beiden durch das Trägerelement getrennten Seiten des Kühlraums miteinander verbinden.

Zur Verbesserung der Kühlung der Bauelemente kann es vorgesehen sein, dass im Bereich der beiden Kühlflächen monolithisch an dem Trägerelement ausgebildete Kühldome in Ausrichtung mit den zu kühlenden Bauelementen angeordnet sind. Diese Kühldome können beispielsweise durch ein wärmeleitendes Medium, oder durch Anlagekontakt, oder aber in relativ geringem Abstand zu den elektronischen Bauelementen angeordnet sein, um die Kühlwirkung zu verbessern bzw. die Wärmeableitung von den elektronischen Bauelementen über die Kühldome zu verbessern.

Eine weitere bevorzugte konstruktive Ausgestaltung sieht vor, dass der Grundkörper außerhalb der Umfangswand einen Anschlussbereich aufweist, in dem der Kühlmitteleinlass und der Kühlmittelauslass angeordnet sind.

Insbesondere im Zusammenhang mit der Möglichkeit, den Kühlkörper unter Nutzung des (Kühl-) Mediums mit einem weiteren, zu kühlenden Aggregat zu verbinden, ist es vorgesehen, dass die Umfangswand auf der der Verschlussplatte abgewandten Stirnseite eine Dichtkontur, vorzugsweise mit einer Aufnahme für ein Dichtelement, aufweist.

Um den Kühlkörper möglichst einfach und effektiv mit einem weiteren, zu kühlenden Aggregat zu verbinden, ist es vorgesehen, dass der Grundkörper Anschlussflansche zum Befestigen des Kühlkörpers mit dem Aggregat aufweist.

Weiterhin umfasst die Erfindung auch eine Anordnung mit einem soweit beschriebenen erfindungsgemäßen Kühlkörper, wobei der Kühlkörper mit einem als Elektromaschine ausgebildeten Aggregat im Bereich der Umfangswand des Grundkörpers verbunden ist.

Weitere Vorteile, Merkmale und Einzelheiten der Erfindung ergeben sich aus der nachfolgenden Beschreibung bevorzugter Ausführungsformen der Erfindung sowie anhand der Zeichnungen.

### Kurze Beschreibung der Zeichnungen

- Fig. 1: zeigt in einer perspektivischen Ansicht einen Teilbereich einer Elektromaschine mit einem an der Elektromaschine befestigten Kühlkörper,
- Fig. 2: den Kühlkörper gemäß Fig. 1 in einer perspektivischen Unteransicht,
- Fig. 3: eine weitere perspektivische Darstellung des Kühlkörpers im Bereich dessen Unterseite und
- Fig. 4: den Kühlkörper gemäß der Fig. 1 in einer perspektivischen Draufsicht.

### Ausführungsformen der Erfindung

Gleiche Elemente bzw. Elemente mit gleicher Funktion sind in den Figuren mit den gleichen Bezugsziffern versehen.

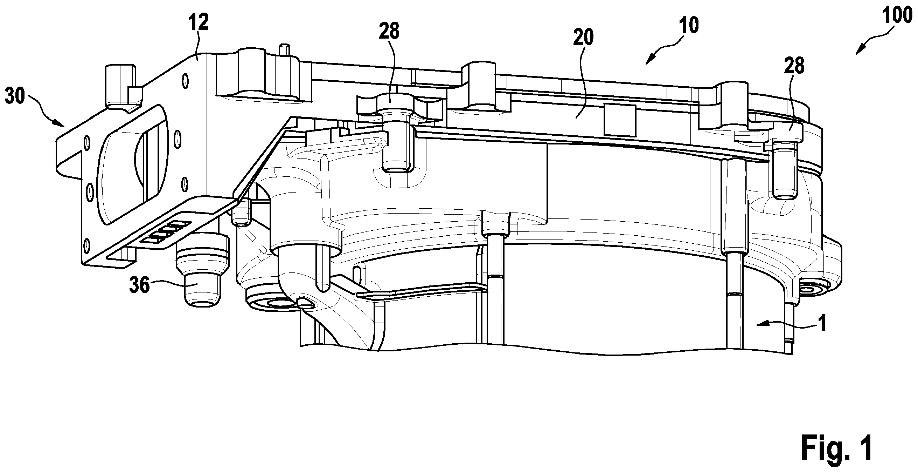

In der Fig. 1 ist eine Anordnung 100 dargestellt, die ein (zu kühlendes) Aggregat in Form einer Elektromaschine 1 und einen Kühlkörper 10 umfasst. Die Elektromaschine 1 ist im Bereich seiner dem Kühlkörper 10 zugewandten (oberen) Stirnfläche mit dem Kühlkörper 10 verbunden, vorzugsweise durch mehrere Schraubverbindungen. Die dem Kühlkörper 10 zugewandte Stirnseite der Elektromaschine 1 ist als geschlossene Fläche ausgebildet, d.h. sie hat keine Verbindung mit dem Innenraum der Elektromaschine 10 (nicht dargestellt).

Die Anordnung 100 ist insbesondere, jedoch nicht einschränkend, im Rahmen der Elektromobilität in Form eines sogenannten Inverters ausgebildet.

Der Kühlkörper 10 besteht im Wesentlichen aus zwei Elementen, einem als Guss- oder Schmiedeteil ausgebildeten Grundkörper 12 und einer Verschlussplatte 14, die wie der Grundkörper 12 aus Metall besteht und die dazu dient, den Grundkörper 12 an der der Elektromaschine 1 abgewandten Seite im Bereich eines Kühlraums 16 mediendicht zu verschließen. Der Kühlraum 16 dient der Aufnahme bzw. der Durchführung des Kühlmediums, insbesondere eines flüssigen Kühlmediums wie einem Wasser/Glykol-Gemisch o.ä. Kühlmedien.

Der Grundkörper 12 weist darüber hinaus innerhalb des Kühlraums 16 ein plattenförmiges Trägerelement 18 auf, das monolithisch mit dem Grundkörper 12 ausgebildet ist, sodass der Grundkörper 12 mit dem Trägerelement 18 ein einstückiges Bauteil ausbildet. Das Trägerelement 18 ist von einer senkrecht zur Ebene des Trägerelements 18 verlaufenden Umfangswand 20 umgeben. Die Umfangswand 20 weist eine Stirnfläche 22 mit einer Aufnahme 24 zur Aufnahme eines Dichtelements 26 in Form einer Dichtung auf. Beim Verbinden des Kühlkörpers 10 mit der Elektromaschine 1 erfolgt eine mediendichte Verbindung mit der zugewandten Stirnseite der Elektromaschine 1 im Bereich der Stirnfläche 22 bzw. mittels des Dichtelements 26. Weiterhin sind zur kraftschlüssigen Verbindung zwischen der Elektromaschine 1 und dem Kühlkörper 10 an dem Kühlkörper 10 mehrere Anschlussflansche 28 außerhalb der Umfangswand 20 angeordnet, über die die angesprochenen Schraubverbindungen mit der Elektromaschine 1 realisiert werden können.

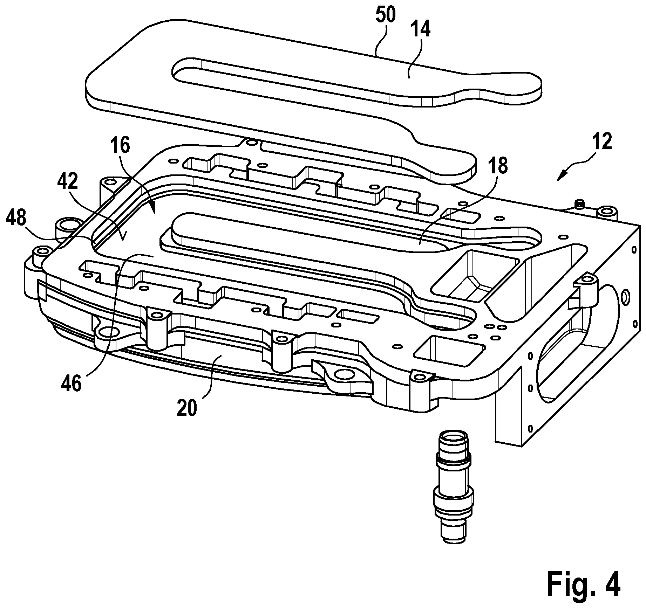

Außerhalb der Umfangswand 20 weist der Kühlkörper 10 einen Anschlussbereich 30 auf. Im Anschlussbereich 30 sind ein Kühlmitteleinlass 32 und ein Kühlmittelauslass 34 für das Kühlmedium angeordnet. Der Kühlmitteleinlass 32 und der Kühlmittelauslass 34 sind in Form von Bohrungen ausgebildet, in die fahrzeugseitige Anschlüsse montierbar sind. Beispielhaft ist in den Fig. 1, 2 und 4 ein Anschlusselement 36 zur Verbindung mit einer Medienzuführung für das Kühlmedium dargestellt. Weiterhin sind in dem Grundkörper 12 in den Figuren nicht erkennbare Kühlmittelkanäle ausgebildet, die den Kühlmitteleinlass 32 bzw. den Kühlmittelauslass 34 mit dem Kühlraum 16 verbinden. Dabei ist die Führung des Kühlmediums derart, dass das Kühlmedium von dem Kühlmitteleinlass 32 auf die der Elektromaschine 1 abgewandte Oberseite des Trägerelements 18 geführt wird. Die Ausleitung des Kühlmediums aus dem Kühlraum 16 erfolgt auf der der Elektromaschine 1 zugewandten Seite des Trägerelements 18.

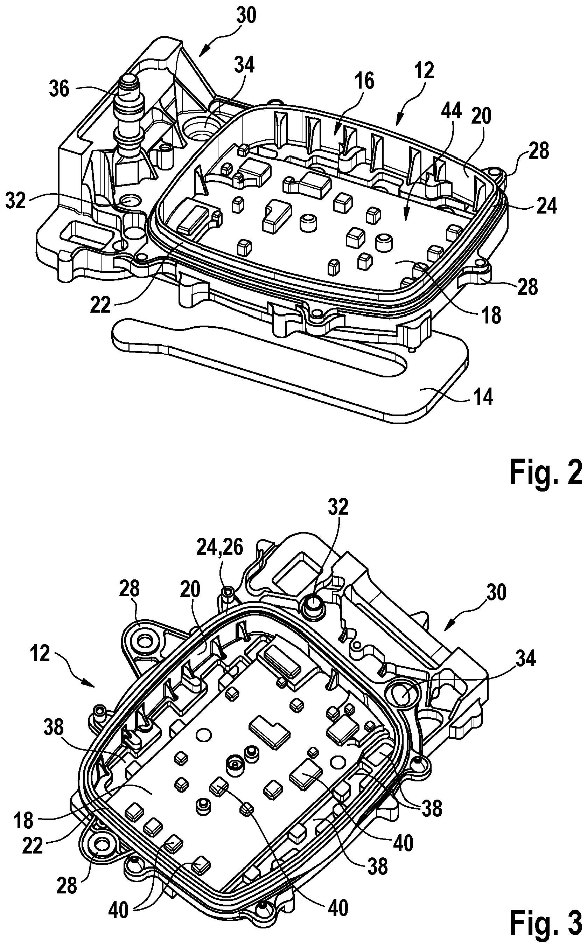

Wie insbesondere anhand der Fig. 3 erkennbar ist, sind zwischen dem Trägerelement 18 und der Umfangswand 20 des Grundkörpers 12 mehrere Durchbrüche 38 ausgebildet, die als Überströmkanäle ein Umströmen des Trägerelements 18 zwischen seinen beiden Seiten ermöglichen. Weiterhin erkennt man an dem Trägerelement 18 monolithisch angeformte Kühldome 40, die in Wirkverbindung mit den (nicht dargestellten) elektronischen Bauelementen angeordnet sind. Hierzu kann beispielsweise ein zusätzliches Wärmeleitmittel Verwendung finden, oder aber ein direkter Anlagekontakt mit den Bauelementen, oder aber es kann ein relativ geringer Abstand zwischen den Kühldomen 40 und den elektronischen Bauelementen vorgesehen sein.

Das Trägerelement 16 bildet auf der, der Elektromaschine 1 abgewandten Seite eine erste Kühlfläche 42 für die elektronischen Bauelemente, und auf der der Elektromaschine 1 zugewandten Seite eine zweite Kühlfläche 44 für die elektronischen Bauelemente aus. Der Kühlkörper 10 ist auf der der Elektromaschine 1 zugewandten Seite offen ausgebildet, d.h., dass eine Ausbildung des geschlossenen Kühlraums 16 (ausschließlich) durch das Verbinden des Kühlkörpers 10 mit der Elektromaschine 1 erfolgt.

Die Anordnung der elektronischen Bauelemente auf der Seite der ersten Kühlfläche 42 erfolgt im Bereich einer U-förmig ausgebildeten, als Kühlkanal wirkenden Vertiefung 46 des Trägerelements 18. Weiterhin erkennt man, dass die U-förmige Vertiefung 46 an ihren randseitigen Begrenzungen eine umlaufende Stufe 48 aufweist, die dazu ausgebildet ist, einen Axialanschlag für die Verschlussplatte 14 auszubilden. Insbesondere ist die Geometrie der Vertiefung 46 an die Kontur 50 der Verschlussplatte 14 formschlüssig angepasst. Die Verschlussplatte 14 bildet mit der Oberseite des Grundkörpers 12 im verbundenen Zustand eine ebene Fläche aus. Eine mediendichte Verbindung zwischen der Verschlussplatte 14 und dem Grundkörper 12 erfolgt dadurch, dass zwischen dem Bereich der Kontur 48 und der angrenzenden Bereiche des Grundkörpers 12 im Bereich der Vertiefung 46 eine Rührreibschweißverbindung (nicht dargestellt) ausgebildet wird, die eine stoffschlüssige Verbindung zwischen der Verschlussplatte 14 und dem Grundkörper 12 erzeugt.

Der soweit beschriebene Kühlkörper 10 kann in vielfältiger Art und Weise abgewandelt bzw. modifiziert werden, ohne vom Erfindungsgedanken abzuweichen.

## Patentansprüche

1. Kühlkörper (10) zur Kühlung von elektronischen Bauelementen, mit einem Grundkörper (12), der eine Umfangswand (20) zur Begrenzung eines Kühlraums (16) aufweist, mit einem innerhalb des Kühlraums (16) angeordneten, vorzugsweise plattenförmigen Trägerelement (18), das auf gegenüberliegenden Seiten eine erste Kühlfläche (42) und eine zweite Kühlfläche (44) aufweist, die dazu ausgebildet sind, die Bauelemente mittels eines Kühlmediums zumindest mittelbar zu kühlen, wobei die erste Kühlfläche (42) im Bereich einer U-förmigen Vertiefung (46) angeordnet ist, die mittels einer Verschlussplatte (14) mediendicht verschließbar ist, wobei der Grundkörper (12) auf der Seite der zweiten Kühlfläche (44) offen ausgebildet ist, derart, dass der Grundkörper (12) mittels der Umfangswand (20) gegen ein mit dem Kühlkörper (10) verbindbares Aggregat (1) mediendicht verbindbar ist, und mit einem Kühlmitteleinlass (32), der dazu ausgebildet ist, zumindest mittelbar Kühlmedium dem Bereich der ersten Kühlfläche (42) zuzuführen sowie einem Kühlmittelauslass (34) zum Ausleiten des Kühlmediums aus dem Kühlraum (16) auf der Seite der zweiten Kühlfläche (44).

2. Kühlkörper nach Anspruch 1,
**dadurch gekennzeichnet,**
**dass** die Verschlussplatte (14) und der Grundkörper (12) im Bereich des Trägerelements (18) mittels einer Rührreibschweißverbindung miteinander stoffschlüssig verbunden sind.

3. Kühlkörper nach Anspruch 1 oder 2,
**dadurch gekennzeichnet,**
**dass** der Grundkörper (12) zusammen mit dem Trägerelement (18) als einstückiges, monolithisches Bauteil ausgebildet ist.

4. Kühlkörper nach Anspruch 3,
**dadurch gekennzeichnet,**
**dass** das Bauteil als Druckgussteil oder als Schmiedeteil ausgebildet ist.

5. Kühlkörper nach einem der Ansprüche 1 bis 4,
**dadurch gekennzeichnet,**
**dass** zwischen der Umfangswand (20) am Grundkörper (12) und dem Trägerelement (18) Durchbrüche (38) in Art von Überströmkanälen für das Kühlmedium ausgebildet sind, wobei die Durchbrüche (38) die beiden durch das Trägerelement (18) getrennten Seiten des Kühlraums (16) miteinander verbinden.

6. Kühlkörper nach einem der Ansprüche 1 bis 5,
**dadurch gekennzeichnet,**
**dass** im Bereich wenigstens einer der beiden Kühlflächen (42, 44) monolithisch mit dem Trägerelement (18) ausgebildete Kühldome (40) in Ausrichtung mit zu kühlenden Bauelementen angeordnet sind.

7. Kühlkörper nach einem der Ansprüche 1 bis 6,
**dadurch gekennzeichnet,**
**dass** der Grundkörper (12) außerhalb der Umfangswand (20) einen Anschlussbereich (30) aufweist, in dem der Kühlmitteleinlass (32) und der Kühlmittelauslass (34) angeordnet sind.

8. Kühlkörper nach einem der Ansprüche 1 bis 7,
**dadurch gekennzeichnet,**
**dass** die Umfangswand (20) auf der der Verschlussplatte (14) abgewandten Stirnseite eine Dichtkontur, vorzugsweise mit einer Aufnahme (24) für ein Dichtelement (26), aufweist.

9. Kühlkörper nach einem der Ansprüche 1 bis 8,
**dadurch gekennzeichnet,**
**dass** der Grundkörper (12) Anschlussflansche (28) zum Befestigen des Kühlkörpers (10) an dem Aggregat (1) aufweist.

10. Anordnung (100) mit einem Kühlkörper (10), nach einem der Ansprüche 1 bis 9 ausgebildet ist, wobei der Kühlkörper (10) mit einem als Elektromaschine ausgebildeten Aggregat (1) im Bereich der Umfangswand (20) verbunden ist.
